# EUROPEAN PATENT APPLICATION

(11) **EP 1 855 326 A1**
(43) Date of publication of application: **14.11.2007**
(21) Application number: 06714583.9
(22) Date of filing: 24.02.2006
(51) Int. Cl.: H01L 33/00, H01L 21/208

(54) **AlGaAs LIGHT EMITTING DIODE HAVING DOUBLE HETERO JUNCTION AND METHOD FOR MANUFACTURING SAME**

(30) Priority: 25.02.2005 JP 2005050761
(71) Applicant: DOWA Electronics Materials Co., Ltd., Chiyoda-ku Tokyo 101-0021 (JP)
(72) Inventor: MURASE, Kenichi, c/o DOWA ELECTRONICS, Chiyoda-ku, Tokyo, 1010021 (JP); ARAKI, Takashi, c/o DOWA ELECTRONICS, Chiyoda-ku, Tokyo, 1010021 (JP)
(74) Representative: Grünecker, Kinkeldey, Stockmair & Schwanhäusser Anwaltssozietät
(86) International application number: PCT/JP2006/303444
(87) International publication number: WO 2006/090841

(57) **Abstract**

A high-speed response AlGaAs light emitting diode which has an emission peak wavelength of 880nm or more and is provided with double hetero junction. The LED is provided with at least three layers of a P-type clad layer (1) composed of a P-type AlGaAs compound, a P-type light emitting layer (2) composed of a P-type AlGaAs compound, and an N-type clad layer (3) composed of an N-type AlGaAs compound. The light emitting layer (2) is added with Si and Ge as dopant.

## Description

### Technical Field

The present invention relates to an AlGaAs-based light emitting diode (referred to as a LED hereafter in some cases) having a double hetero junction used for information spade transmission, and a manufacturing method of the same.

### Background art

In recent years, each kind of small-sized portable terminal device (electronic device) has been developed, and for example, the small-sized portable terminal device having both of data communication function and a remote control operation function has been developed. Here, in an infrared ray communication system between the small-sized portable terminal device having both of the remote control operation function and the data communication function and a main device that performs transfer of information with this small-sized portable terminal device, it is general to perform remote control operation of the main device at an interval of about 5m between the small-sized portable terminal device and the main device by using an infrared ray of a long wavelength (such as 880nm or more) as the remote control operation function, and meanwhile perform data transfer between the small-sized portable terminal device and the main device at an interval of about 50cm to 1m therebetween by using the infrared ray of a short wavelength (such as 870nm or less) as the data communication function. Here, as a light emitting element of this infrared ray, an AlGaAs-based LED having the double hetero junction (DH structure) is generally used, out of the LEDs for emitting light by flowing current in a forward direction of the PN junction of a compound semiconductor.

Incidentally, the remote control operation and the data communication use infrared rays of different wavelengths. The reason is as follows.
Namely, in a case of the remote control operation, the small-sized portable terminal device and the main device are set apart from each other, and therefore the infrared ray emitted by the small-sized portable terminal device is required to be received with high sensitivity. Then, the sensitivity of a sensor for receiving the infrared ray is excellent in the longer wavelength (such as 880nm or more). Therefore, as the LED for emitting light by the remote control operation in the small-sized portable terminal device, the LED for emitting light of the longer wavelength is used.
Meanwhile, in a case of the data communication, a large quantity of data is required to be transmitted for a short period of time. Therefore, the LED having fast ON-OFF responsiveness is required. Then, as the LED of the fast responsiveness, for example, the LED disclosed in a patent document 1 is developed and used. However, the LED disclosed in this patent document 1 is also the LED for emitting the infrared ray of a shorter wavelength such as 870nm or less.
Accordingly, at present, the small-sized portable device provided with two kinds of LEDs such as the LED for remote control operation of emitting light of the longer wavelength and the LED for data transmission of emitting light of the shorter wavelength, are used.
Patent document 1: Patent No.3187279

### Disclosure of the Invention

### Problem to be solved

In order to respond to a request of a further smaller size and a request of lower cost to this small-sized portable terminal device, the two kinds of the LEDs such as the LED for remote control operation and the LED for data communication are required to be unified.
As a method of such unification, a method of making an emission wavelength of the LED for remote control operation shorter and a method of making the emission wavelength of the LED for data transmission longer, are considered. However, in the method of making the emission wavelength of the LED for remote control operation shorter, there is newly generated a problem that the sensitivity has to be increased in a shorter wavelength region of a light receiving sensor as described above. Therefore, inventors of the present invention try to make the emission wavelength of the LED for data communication longer. However, when a composition and a film thickness of an active layer of the LED for data transmission are examined and the emission wavelength of the LED for data transmission is made to be longer, it is found that a responsiveness speed and an emission output are deteriorated.

In view of the above-described circumstances, the present invention is provided, and an object of the present invention is to provide the LED capable of exhibiting high responsiveness even in the longer wavelength such as 880nm or more as a peak wavelength of light emission, and the manufacturing method of the same.

### Means to solve the Problem

As a result of strenuously studying the aforementioned object, it is found by the inventors of the present invention that by selecting Si and Ge as a dopant in an emission layer in the AlGaAs-based light emitting diode first, the LED capable of exhibiting fast responsiveness even in an emission peak wavelength of 880nm or more can be obtained. Then, as a result of further study by the inventors of the present invention, it is found that by selecting Si and Ge as the dopant, drop of a reverse voltage (referred to as Vr hereafter in some cases) after lighting the AlGaAs-based light emitting diode for a prescribed time can be suppressed.

Namely, a first invention provides a light emitting diode, including:
at least one layer of P-type clad layer containing a P-type AlGaAs compound;
at least one layer of emission layer containing the P-type AlGaAs compound; and
at least one layer of N-type clad layer containing an N-type AlGaAs compound,
wherein the emission layer has a double hetero junction containing Si and Ge.

A second invention provides the light emitting diode, which is an AlGaAs-based light emitting diode having a double hetero junction described in the first invention, wherein a molar ratio of Si and Ge contained in the emission layer is 0 < Ge / Si ≤ 5.

A third invention provides the light emitting diode, which is the AlGa-based light emitting diode having the double hetero junction described in the first invention, wherein the molar ratio of Si and Ge contained in the emission layer is 5 < Ge / Si.

A fourth invention provides the light emitting diode, which is the AlGaAs-based light emitting diode having the double hetero junction according to any one of the first to third inventions, wherein the P type clad layer contains at least more than one kind of the elements selected from Zn, Mg, and Ge.

A fifth invention provides a manufacturing method of the light emitting diode according to the fifth invention, which is a manufacturing method of the AlGaAs-based light emitting diode having the double hetero junction, wherein when at least three layers of the P-type clad layer, emission layer, and N-type clad layer are epitaxial-grown on a GaAs substrate by using a liquid phase epitaxial growth method, Si and Ge are added to the emission layer.

### Advantage of the Invention

The AlGaAs-based light emitting diode having the double hetero junction of the first invention has the emission peak wavelength of the longer wavelength such as 880nm or more. Therefore, the fast responsiveness can be exhibited.

The AlGaAs-based light emitting diode having the double hetero junction of the second invention has the emission peak wavelength of the longer wavelength such as 880nm or more. Therefore, the fast responsiveness can be exhibited, and a Vr value after lighting this light emitting diode for a prescribed time can be maintained at a high level.

The AlGaAs-based light emitting diode having the double hetero junction of the third invention has the emission peak wavelength of the longer wavelength such as 880nm or more. Therefore, the fast responsiveness can be exhibited, and the Vr value after lighting this light emitting diode for a prescribed time can be maintained at a high level.

The AlGaAs-based light emitting diode having the double hetero junction of any one of the first to third inventions has the emission peak wavelength of the longer wavelength such as 880nm or more. Therefore, the fast responsiveness can be exhibited, and drop of the Vr value after lighting this light emitting diode for a prescribed time can be suppressed, and in addition, output and reliability are improved.

According to the manufacturing method of the LED of the fourth invention, it is possible to easily manufacture the AlGaAs-based light emitting diode having the double hetero junction capable of exhibiting the fast responsiveness in the emission peak wavelength of 880nm or more, in the same step of a conventional light emitting diode.

### Best Mode for Carrying out the Invention

Preferred embodiments of the present invention will be explained hereunder.

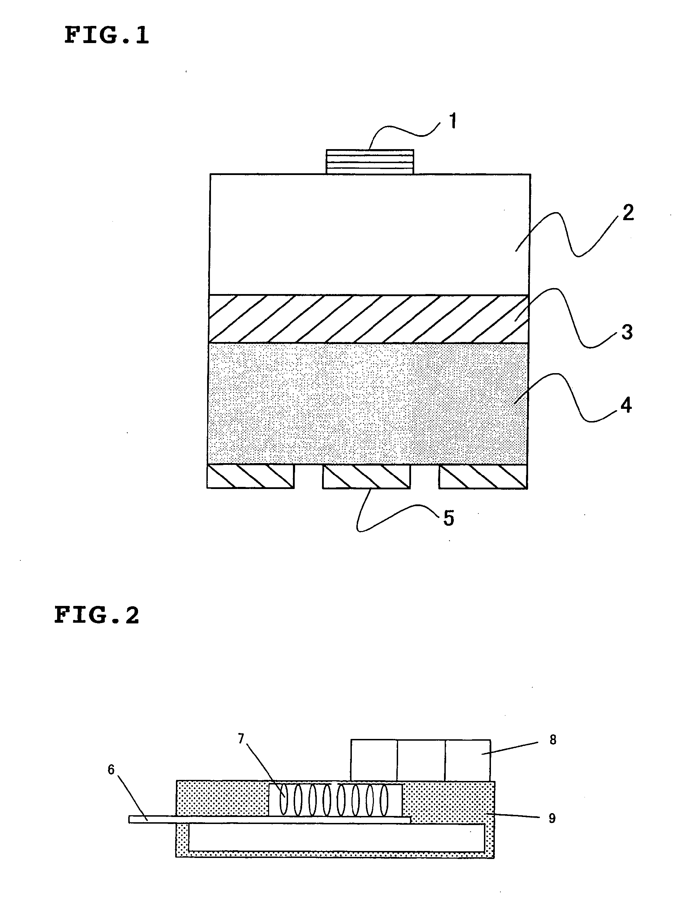

First, the structure of the LED according to an embodiment of the present invention will explained with reference to FIG.1.

FIG.1 is a schematic sectional view of the AlGaAs-based LED having the double hetero junction (DH structure) according to the embodiment of the present invention, showing an upper surface electrode 1, an N-type clad layer 2, an emission layer 3, a P-type clad layer 4, and a rear surface electrode 5 in an order from the top.

In addition, the LED of the present invention is the AlGaAs-based LED, with a so-called GaAs substrate removed, and therefore FIG.1 shows a state after the GaAs substrate is removed. Here, the N-type clad layer 2 includes N-type AlₓGa₁₋ₓAs(wherein 0.15 ≤ x ≤ 0.45), the emission layer 3 includes P-type AlₓGa₁₋ₓAs (wherein 0 ≤ x ≤ 0.1), and the P-type clad layer 4 includes P-type AlₓGa₁₋ₓAs (wherein 0.15 ≤ x ≤ 0.45).

Here, the N-type clad layer 2 and the P-type clad layer 4 have AlₓGa₁₋ₓAs phases. However, in this AlₓGa₁₋ₓAs phase, an Al ratio is desirably 0.15 ≤ x ≤ 0.45. This is because when the Al ratio is set at 0.15 or more, an advantage of confining electrons and holes can be obtained. Meanwhile, by setting the Al ratio at 0.45 or less, a problem of corrosive deterioration of elements through power feeding can be prevented, and further ohmic loss is prevented from generating in an interface between this clad layer and an electrode, and in an interface between clad layers, and an increase of a voltage in the forward direction is prevented from occurring.

In addition, when the Al ratio of the emission layer 3 is in a range of 0 ≤ x ≤ 0.1, the emission wavelength of the AlGaAs-based LED of the present invention can be easily made longer to the wavelength of 870nm or more, and this is preferable.

A dopant density of the N-type clad layer 2 is 0.5 × 10¹⁸/cm³ or more and 0.8 × 10¹⁸/cm³ or less, and its dopant is preferably Te or Si.

Preferably, the dopant density of the emission layer 3 is 1 × 10¹⁸ or more and 2 × 10²⁰/cm³ or less, its dopant is Si and Ge, and its thickness is in a range of 0.2µm to 1.5µm.
When a value of Ge/Si (molar ratio) in the dopant is beyond 0 (i.e. only Si) and is in a range of 5 or less, it is found that the same degree of speed of responsiveness (rise time and fall time) as a case of emitting light at a wavelength of 870nm can be obtained, while the peak wavelength of the light emission of this LED is 880nm or more, and an emission output is the same.

Further, when the value of Ge/Si (molar ratio) exceeds 5, and when the emission peak wavelength of this LED is 880nm or more by increasing the current flowing through this LED, it is found that the emission output is deteriorated by about 20% compared to a case of causing light emission at the peak wavelength of 870nm, but the responsiveness becomes faster by twice. Therefore, a large quantity of data can be communicated at a high-speed.
Meanwhile, it is found that when only Ge is selected as the dopant, the emission wavelength of this LED can not be made longer, and the light emission can not be caused in a wavelength range in which the sensitivity of a light receiving element is excellent.

Here, the rise time, being an index of a response speed, refers to the time required for the emission output of this LED to become 90% of a maximum emission output from 10% thereof. Moreover, the fall time refers to the time required for vanishing an electrical signal given to the LED and for the emission output of this LED to become 10% of the maximum emission output from 90% thereof. These rise time and fall time can be obtained by converting the light emitted by the LED to the electrical signal by the light receiving element, which is then monitored by an oscilloscope.

The rise time and the fall time are required to be set to at least 40ns or less for the LED used in a large quantity of data communication for a short period of time. Therefore, if the rise time and the fall time are designed to be 30ns or less in this LED, the LED is allowed to have a margin of about 10ns, thus significantly contributing to reducing a defect rate of the LED and improving a yield, and this is preferable.

Next, the Vr value (a reverse voltage value) is required to be higher for this LED, because the Vr value is not required to be decreased even after power feeding for 1000 hours, so as to prevent a circuit having the LED mounted thereon from being damaged due to a fluctuation of this circuit.

Therefore, as a result of studying on a decrease of the Vr value due to integration of the power feeding and lighting time, it is found that when the Vr value before power feeding and lighting is standardized as 1, and when the Vr value is maintained at 0.75 or more at the time point of power feeding and lighting for about 1000 hours, reliability of the circuit incorporating the LED is improved. Then, when only Si is selected as the dopant, the Vr value is decreased to under 0.75 after power feeding and lighting for 1000 hours. However, when the dopant is 0.03 or more of Ge/Si (molar ratio), the Vr value is maintained at 0.75 or more after power feeding and lighting for 1000 hours.

In addition, as the dopatn of the P-type clad layer 4, preferably at least more than one kind of element selected from Zn, Mg, and Ge is used at a density of 0.5 × 10¹⁸/cm³ or more and 2 × 10¹⁸cnm⁻³ or less. By setting this dopant density at 0.5 × 10¹⁸/cm³ or more and 2 × 10¹⁸/cm³ or less, the LED having a sufficient output and reliability can be obtained.

In addition, a control of each dopant density can be easily performed by operating a mixing amount of a Ge raw material and a Si raw material for manufacturing the LED.

The LED having the aforementioned structure shows the reliabitlity that the emission output is maintained by 75% of an initial output even after elapse of 1000 hours, through power feeding of 100mA in an atmosphere of a room temperature.

Next, the manufacturing method of the LED according to the embodiment of the present invention will be explained with reference to FIGs 1 and 2. Here, FIG. 2 is a schematic sectional view of a manufacturing device of the LED.
Growths of the N-type clad layer 2, emission layer 3, and P-type clad layer 4 are conducted by a slow-cooling method, for example, and the temperature in the vicinity of a substrate during growth is managed in a range from 600°C to 900°C. A GaAs substrate is used for the substrate, and the growths of the N-type clad layer 2, emission layer 3, and P-type clad layer 4 are sequentially conducted. The GaAs substrate used here may be any one of P-type, N-type, semi-insulating, and undope layers. Further, an order of growth may be an order of the P-type clad layer 4, emission layer 3, and N-type clad layer 2.

In addition, the LED of the present invention can have the same characteristic even if a chip upper surface may be either N-type or P-type, and this is not dependent on the aforementioned growth order. Moreover, a shape of an electrode on both sides of upper and lower surfaces can be arbitrarily selected. The growth of each layer can have the same characteristic even if a temperature difference method is used. However, the slow-cooling method whereby a plurality of sheets can be simultaneously grown is advantageous in a mass production.

The epitaxial growth of the aforementioned each of the layers 1 to 3 will be further explained by using the schematic sectional view of the manufacturing device of the LED as shown in FIG.2.
As shown in FIG.2, the manufacturing device of the LED is composed of three points such as a carbon growing jig 8, a base 9, and a partition 6.
The growing jig 8 is composed of at least three baths. This is because three baths with different component and dopant necessary for the epitaxial growth of the P-type clad layer 4, emission layer 3, and N-type clad layer 2 are required.

Each bath of the growing jig is filled with a Ga raw material, an Al raw material, a GaAs raw material, and dopant which are blended appropriately, so as to have the same composition as that of each clad layer and emission layer having a prescribed composition. At this time, the bath filled with raw materials of the emission layer is filled with a Si raw material and a Ge raw material, which are weighed in accordance with prescribed Ge/Si (molar ratio) to be added as the dopant of the emission layer.

In addition, a GaAs substrate 7 is housed in the base 9. The GaAs substrate 7 at this time is removed at the time of manufacturing the device in a post-process, and therefore any one of P-type, N-type, and nondope may be used. Then, the temperature in the vicinity of the substrate 7 housed in the base 9 until completion of growth of the third layer from starting the growth of the first layer is 900°C at the time of starting the growth of the first layer, and it is gradually lowered and is preferably 600°C at the time of completing the growth of the third layer.

Subsequent epitaxial growth of the P-type clad layer 4, the emission layer 3, and the N-type clad layer 2 on the GaAs substrate 7 is the same as the manufacture of the AlGaAs-based LED having the conventional double hetero junction (DH structure) by means of a normal liquid layer epitaxial growth.
Namely, a raw material melt is introduced into the base 9 in which the GaAs substrate 7 is housed, then is epitaxial-grown on the GaAs substrate 7 at a prescribed temperature, time, and slow cooling speed, and thereafter by operating the partition 6, the residual raw material melt is separated from the GaAs substrate 7. By repeating this operation, each layer is allowed to grow.
Here, explanation is returned to FIG.1, when the epitaxial growth of each layer on the GaAs substrate is completed, the GaAs substrate is removed, the upper elelctrode 1 and the rear surface electrode 5 are set, the epitaxial layer is formed into a chip, and wiring is performed to the electrode, to thereby obtain the LED. This process is the same as the process of the AlGaAs-based LED having the conventional double hetero junction (DH structure).
Note that after division of the epitaxial layer into a chip, in order to efficiently extract lights from this chip, preferably the surface of this chip is roughened.

In the small-sized portable terminal using the LED of the present invention thus obtained, a data transfer function and a remote control operating function for transferring the information between this small-sized portable terminal and the main device can be performed by this one LED. As a result, miniaturization, simplification, and reducing cost of the small-sized portable terminal can be realized. Further, the LED of the present invention is not limited to the aforementioned small-sized portable terminal, and can be applied to each kind of purpose of use for performing data transmission at a high-speed, by using a longer wavelength of more than 880nm.

### Example

The present invention will be more specifically explained based on an example.

### (Example 1)

This example shows a growth of the P-type clad layer 4, the emission layer 3, and the N-type clad layer 2 in this order.

First, as a growing material of the P-type clad layer, GaAs24.5g, A10.91g, and An0.11g were blended.

Next, as the growing material of the emission layer, GaAs50.6g, A10.072g, Si0.55g, and Ge1.385g were blended to Ga550g. Further, as the growing material of the N-type clad layer, GaAs28.8g, A10.77g, Te0.014g were blended to Ga550g. Note that at this time, the dopant density of the active layer of Si and Ge of the emission layer is (5 × 10¹⁸)/cm³ as Si quantity, and (1 × 10¹⁸)/cm³ as Ge quantity.

After each bath provided in the growth jig is filled with growing materials of each layer, this growing jig is put in a growing furnace, then, after sufficiently exhausting nitrogen and oxygen contained in an atmospheric air from the furnace by evacuation, in-furnace was replaced with high purity hydrogen and set in a high purity hydrogen flow. (Note that the GaAs substrate is set in this growing jig). Then, the temperature in the growing furnace in the high purity hydrogen flow is raised to 920°C, and this temperature is maintained for stabilizing in-furnace temperature. Here, the growing materials of each layer filled in each bath provided in the growing jig become the raw material melt.

Next, the GaAs substrate set in this growing jig is moved to a lower part of a growing material melt bath of the P-type clad layer, to start the growth of the P-type clad layer. However, at this time, the raw material melt is brought into contact with the GaAs substrate at 900°C, and while further decreasing the temperature, AlₓGa₁₋ₓAs with thickness of 50µm (wherein x = 0.35) and the P-type clad layer with dopant density of 0.7 × 10¹⁸/cm³ are grown, and after completing the growth, the growing material melt of the P-type clad layer and the GaAs substrate are separated from each other.

After the growing material of the P-type clad layer and the GaAs substrate are separated from each other, next, the GaAs substrate on which this p-type clad layer is grown, and the growing material melt of the P-type emission layer are come in contact with each other, and AlₓGa₁₋ₓAs with a thickness of 0.5µm (wherein x = 0) and the P-type emission layer with dopant density of 1.5 × 10¹⁸/cm³ are grown, and after completing the growth, the growing material melt of the emission layer and the GaAs substrate are separated from each other.

After separating the growing material of the emission layer and the GaAs substrate are separated from each other, while further decreasing the temperature, the GaAs substrate on which this emission layer is grown and the growing material melt of the N-type clad layer are brought into contact with each other, and AlₓGa₁₋ₓAs with a thickness of 100µm (wherein x = 0.40) and the N-type clad layer with dopant density of 1 × 10¹⁸/cm³ are grown at 600°C, and after completing the growth, the growing material melt of the N-type clad layer and the GaAs substrate are separated from each other and the temperature is decreased to a room temperature.

The GaAs substrate was removed from the GaAs substrate on which the P-type clad layer, the emission layer, and the N-type clad layer thus obtained were epitaxial-grown, and the LED according to a sample 1 of the example 1 was manufactured.
The emission output and the peak wavelength of the emission at the time of flowing the current of DC20mA to the manufactured LED of the sample 1, rise time and fall time at the time of flowing a pulse current of 500mA thereto, and the Vr value after power feeding and lighting for 1000 hours, with the Vr value before power feeding and lighting standardized as 1, were measured. Then, it was found that the emission output was 5.2mW, the peak wavelength of emission was 882nm, the rise time was 20nS, the fall time was 25nS, and the Vr value was 1.00. These results are shown in table 1.

Next, the LED of a sample 2 was manufactured by performing the same operation as the sample 1, other than that the dopant density of the active layer of Si and Ge of the emission layer was set at 2 × 10¹⁸/cm³ for Si quantity and 0 for Ge quantity.
The emission output and the peak wavelength of the emission at the time of flowing the current of DC20mA to the manufactured LED of the sample 2, the rise time and the fall time at the time of flowing the pulse current of 500mA thereto, and the Vr value after power feeding and lighting for 1000 hours, with the Vr value before power feeding and lighting standardized as 1, were measured. Then, it was found that the emission output was 5mW, the peak wavelength of the emission was 882nm, the rise time was 20nS, the fall time was 25nS, and the Vr value was 0.68. These results are shown in table 1.

Next, the LED of a sample 3 was manufactured by performing the same operation as the sample 1, other than that the dopant density of the active layer of Si and Ge of the emission layer was set at 1 × 10¹⁹/cm³ for Si quantity, and 4 × 10¹⁷/cm³ for Ge quantity.

Then, the emission output and the peak wavelength of the emission at the time of flowing the current of DC20mA to the manufactured LED of the sample 2, the rise time and the fall time at the time of flowing the pulse current of 500mA thereto, and the Vr value after power feeding and lighting for 1000 hours, with the Vr value before power feeding and lighting standardized as 1, were measured. Then, it was found that the emission output was 4.8mW, the peak wavelength of the emission was 893nm, the rise time was 19nS, the fall time was 24nS, and the Vr value was 0.78. These results are shown in table 1.

Next, the LED of a sample 4 was manufactured by performing the same operation as the sample 1, other than that the dopant density of the active layer of Si and Ge of the emission layer was set at 5 × 10¹⁸/cm³ for Si quantity and 7 × 10¹⁷ for Ge quantity.
Then, the emission output and the peak wavelength of the emission at the time of flowing the current of DC20mA to the manufactured LED of the sample 4, the rise time and the fall time at the time of flowing the pulse current of 500mA thereto, and the Vr value after power feeding and lighting for 1000 hours, with the Vr value before power feeding and lighting standardized as 1, were measured. Then, it was found that the emission output was 5.1mW, the peak wavelength of the emission was 883nm, the rise time was 20nS, the fall time was 25nS, and the Vr value was 0.82. These results are shown in table 1.

Next, the LED of a sample 5 was manufactured by performing the same operation as the sample 1, other than that the dopant density of the active layer of Si and Ge of the emission layer was set at 5 × 10¹⁸/cm³ for Si quantity and 1 × 10¹⁹/cm³ for Ge quantity.
Then, the emission output and the peak wavelength of the emission at the time of flowing the current of DC20mA to the manufactured LED of a sample 5, the rise time and the fall time at the time of flowing the pulse current of 500mA thereto and the Vr value after power feeding and lighting for 1000 hours, with the Vr value before power feeding and lighting standardized as 1, were measured. Then, it was found that the emission output was 4.7mW, the peak wavelength of the emission was 884nm, the rise time was 18ns, the fall time was 18ns, and the Vr value was 1.00. These results are shown in table 1.

Next, the LED of a sample 6 was manufactured by performing the same operation as the sample 1, other that that the dopant density of the active layer of Si and Ge of the emission layer was set at 2 × 10¹⁸/cm³ for Si quantity and 7 × 10¹⁸/cm³ for Ge quantity.
Then, the emission output and the peak wavelength of the emission at the time of flowing the current of DC20mA to the manufactured LED of the sample 6, the rise time and the fall time at the time of flowing the current of 500mA thereto, and the Vr value after power feeding and lighting for 1000 hours, with the Vr value before power feeding and lighting standardized as 1, were measured. Then, it was found that the emission output was 4.34mW, the peak wavelength of the emission was 880nm, the rise time was 23ns, the fall time was 28ns, and the Vr value was 1.00. These results are shown in table 1.

Next, the LED of a sample 7 was manufactured by performing the same operation as the sample 1, other than that the dopant density of the active layer of Si and Ge of the emission layer was set at 7 × 10¹⁸/cm³ for Si quantity, and 7 × 10¹⁹/cm³ for Ge quantity.
Then, the emission output and the peak wavelength of the emission when flowing the current of DC20mA to the manufactured LED of the sample 7, the rise time and the fall time at the time of flowing the pulse current of 500mA thereto, and the Vr value after power feeding and lighting for 1000 hours, with the Vr value before power feeding and lighting standardized as 1, were measured. Then, it was found that the emission output was 2.32m W, the peak wavelength of the emission was 892nm, the rise time was 7ns, the fall time was 8ns, and the Vr value was 1.00. These results are shown in table 1.

Next, the LED of an eighth sample was manufactured by performing the same operation as the sample 1, other than that the dopant density of the active layer of Si and Ge of the emission layer was set at 5 × 10¹⁷/cm³ for Si quantity and 4 × 10¹⁹/cm³ for Ge quantity.
Then, the emission output and the peak wavelength of the emission at the time of flowing the current of DC20mA to the manufactured LED of the sample 8, the rise time and fall time at the time of flowing the pulse current of 500mA thereto, and the Vr value after power feeding and lighting for 1000 hours, with the Vr value before power feeding and lighting standardized as 1, were measured. Then, it was found that the emission output was 3.32mW, the peak wavelength of the emission was 880nm, the rise time was 8ns, the fall time was 8ns, and the Vr value was 1.00. These results are shown in table 1.

Next, the LED of a ninth sample was manufactured by performing the same operation as the sample 1, other than that the dopant density of the active layer of Si and Ge of the emission layer was set at 5 × 10¹⁷/cm³ for Si quantity and 1 × 10²⁰/cm³ for Ge quantity.
Then, the emission output and the peak wavelength of the emission at the time of flowing the current of DC20mA to the manufactured LED of a sample 9, the rise time and the fall time at the time of flowing the pulse current of 500mA, and the Vr value after power feeding and lighting for 1000 hours, with the Vr value before power feeding and lighting standardized as 1, were measured. Then, it was found that the emission output was 3.5mW, the peak wavelength of the emission was 882nm, the rise time was 8ns, the fall time was 8ns, and the Vr value was 1.00. These results are shown in table 1.

### (Comparative example 1)

The LED of a comparative example 1 was manufactured by performing the same operation as the example 1, other than that the dopant density of the active layer of Si and Ge of the emission layer was set at 0 for Si quantity and 1 ×10¹⁸/cm³ for Ge quantity.
Then, the emission output and the peak wavelength of the emission at the time of flowing the current of DC20m A to the manufactured LED, the rise time and the fall time at the time of flowing the pulse current of 500mA thereto, and the Vr value after power feeding and lighting for 1000 hours, with the Vr value before power feeding and lighting standardized as 1, were measured. Then, it was found that the emission output was 5.2mW, the peak wavelength of the emission was 870nm, the rise time was 20ns, the fall time was 25ns, and the Vr value was 1.00. These results are shown in table 1.

**(Table 1)**

| | EXAMPLE 1 | | | | | | | | | COMPARATIVE EXAMPLE 1 |
|---|---|---|---|---|---|---|---|---|---|---|
| | SAMPLE 2 | SAMPLE 3 | SAMPLE 4 | SAMPLE 1 | SAMPLE 5 | SAMPLE 6 | SAMPLE 7 | SAMPLE 8 | SAMPLE 9 | |
| Si[/cm³] | 2×10¹⁸ | 1×10¹⁹ | 5×10¹⁸ | 5×10¹⁸ | 5×10¹⁸ | 2×10¹⁸ | 7×10¹⁸ | 5×10¹⁷ | 5×10¹⁷ | 0 |
| Ge[/cm³] | 0 | 4×10¹⁷ | 7×10¹⁷ | 1×10¹⁸ | 1×10¹⁹ | 7×10¹⁸ | 7×10¹⁹ | 4×10¹⁹ | 1×10²⁰ | 1×10¹⁸ |
| Ge/Si (MOLAR RATIO) | 0 | 0.03 | 0.15 | 0.31 | 3.07 | 3.07 | 9.22 | 92.21 | 307.37 | - |
| Po[mW] | 5 | 4.8 | 5.1 | 5.2 | 4.7 | 4.34 | 2.32 | 3.32 | 3.5 | 5.2 |
| PEAK WAVELENGTH[nm] | 882 | 893 | 883 | 882 | 884 | 880 | 892 | 880 | 882 | 870 |
| RISING TIME[ns] | 20 | 19 | 20 | 20 | 18 | 23 | 7 | 8 | 8 | 20 |
| FALLING TIME[ns] | 25 | 24 | 25 | 25 | 18 | 28 | 8 | 8 | 8 | 25 |
| Vr value standardized after power feeding for 1000 hours | 0.68 | 0.78 | 0.82 | 1.00 | 1.00 | 1.00 | 1.00 | 1.00 | 1.00 | 1.00 |

### (ESD resistance test)

Next, an ESD(Electrostatic Discharge) resistance test was conducted by using the sample 1 of the example 1 and the sample of the comparative example 1.
Both samples were mounted on a regulated TO-18 stem, respectively, which were then molded by using ECR-7217 and ECH-7217 of Sumitomo Bakelite Co., Ltd. by using epoxy resin obtained by mixing ECR-7217 and ECH-7217 at a ratio of 1 : 1. Note that two cycles of heat-treatment is a curing condition of this epoxy resin wherein the epoxy resin is subjected to heat-treatment for one hour at 115°C and subsequently subjected to heat-treatment for five hours at 150°C.
Here, emission intensity of both samples at the time of power feeding of 100mA was measured by an entire emission measurement using an integrating sphere, and the emission intensity thus measured was standardized as 1, respectively.

Next, voltage was applied to the both samples thus mounted on the stem five times, with voltages of 4000V and 300V set as two levels, under a SD-4701 condition of an EIAJ standard.
A power feeding test was conducted to the both samples after voltage application in a room temperature under the condition of power feeding quantity of DC100Ma, power feeding time of 168 hours, 500 hours, and 1000 hours, and the emission intensity (power feeding amount of DC100mA) of the both samples in each power feeding time was measured. Then, an output ratio was obtained by comparing the emission intensity of the both samples thus measured and the emission intensity before the application of the voltage standardized as 1. This output ratio is shown in table 2.

**(Table 2)**

| | APPLICATION VOLTAGE | | | |
|---|---|---|---|---|
| | 4000V | | 300V | |
| | SAMPLE 1 | COMPARATIVE EXAMPLE 1 | SAMPLE 1 | COMPARATIVE EXAMPLE 1 |
| AFTER RESIN MOLDING (STANDERDIZED VALUE) | 1.00 | 1.00 | 1.00 | 1.00 |
| OUTPUT RATIO AFTER 168 HOURS | 0.99 | 0.94 | 0.98 | 0.92 |
| OUTPUT RATIO AFTER 500 HOURS | 0.98 | 0.91 | 0.98 | 0.89 |
| OUTPUT RATIO AFTER 1000 HOURS | 0.97 | 0.89 | 0.97 | 0.86 |

### (Summary of the example 1 and the comparative example 1)

From a test result of LED samples of the example 1, it was found that in the AlGaAs-based light emitting diode having a double hetero junction including at least one layer of clad layer containing the P-type AlGaAs compound, at least one layer of emission layer containing the P-type AlGaAs compound, and at least one layer of N-type clad layer containing the N-type AlGaAs compound, the peak wavelength in the emission wavelength could be set at 880nm, while a response speed of the rise time and the fall time at the time of flowing the pulse current of 500mA was maintained at 30ns or less. Meanwhile, according to the test result of the LED sample of the comparative example 1 not containing Si in the emission layer, the peak wavelength in the emission wavelength could not be set at 880nm or more.

Then, in the LED sample of the example 1, it was found that when the molar ratio of Si and Ge contained in the emission layer satisfies the inequality of 0 < Ge/Si, the Vr value after power feeing and lighting for 1000 hours was improved, thus providing the LED suitable for data transmission.

Further, in the LED sample of the example 1, the molar ratio of Si and Ge contained in the emission layer satisfies the inequality of 0 < Ge/Si ≤ 5, the emission output equivalent to the conventional data transmitting LED could be obtained.

In addition, in the LED sample of the example 1, when the molar ratio of Si and Ge contained in the emission layer satisfied the inequality of 5 < Ge/Si, it was found that the response speed of rise time and fall time was increased to be 10ns or less. Accordingly, this LED is suitable for the purpose of use particularly requiring a high-speed response.

Further, from the result of table 2, almost no change of an optical output was found in the sample doping Si and Ge in the emission layer from the ESD resistance test and even after power feeding for 1000 hours, compared to the sample doping only Ge into the emission layer, and therefore it was found that the LED has a high reliability.

### Brief Description of the Drawings

FIG.1 is a schematic sectional view of an LED according to an embodiment of the present invention.
FIG.2 is a schematic sectional view of a manufacturing device of the LED according to the embodiment of the present invention.

### Description of Signs and Numerals

- 1: Upper electrode
- 2: N-type clad layer
- 3: Emission layer
- 4: P-type clad layer
- 5: Rear surface electrode
- 6: Partition
- 7: GaAs substrate
- 8: Growing jig
- 9: Base

## Claims

1. An AlGaAs-based light emitting diode having a double hetero junction structure, comprising:
at least one layer of P-type clad layer containing a P-type AlGaAs compound;
at least one layer of emission layer containing a P-type AlGaAs compound; and
at least one layer of N-type clad layer containing an N-type AlGaAs compound,
wherein Si and Ge are contained in said emission layer.

2. The AlGaAs-based light emitting diode having the double hetero junction according to claim 1, wherein the molar ratio of Si and Ge contained in said emission layer is in a range of 0 < Ge/Si ≤ 5.

3. The AlGaAs-based light emitting diode having the double hetero junction according to claim 1, wherein the molar ratio of Si and Ge contained in said emission layer is in a range of 5 < Ge/Si.

4. The AlGaAs-based light emitting diode having the double hetero junction according to any one of claims 1 to 3, wherein at least more than one kind selected from Zn, Mg, and Ge are contained in said P-type clad layer.

5. The AlGaAs-based light emitting diode having the double hetero junction, wherein when at least three layers of P-type clad layer, emission layer, and N-type clad layer are epitaxial grown by a liquid phase epitaxial growth method on a GaAs substrate, said emission layer is added with Si and Ge.
